Europäisches Patentamt

European Patent Office

Office européen des brevets

(11) Publication number: **0 390 503**
**A1**

## (12) EUROPEAN PATENT APPLICATION

(21) Application number: 90303260.5

(22) Date of filing: 27.03.90

(51) Int. Cl.5: **C30B 15/12, C30B 15/14**

(30) Priority: 30.03.89 JP 76699/89
23.08.89 JP 217104/89

(43) Date of publication of application:
03.10.90 Bulletin 90/40

(84) Designated Contracting States:
DE FR GB IT NL

(71) Applicant: NKK CORPORATION
1-2 Marunouchi 1-chome, Chiyoda-ku
Tokyo(JP)

(72) Inventor: Kamio, Hiroshi, c/o NKK Corporation
1-2 Marunouchi 1-chome
Chiyoda-ku, Tokyo(JP)
Inventor: Araki, Kenji, c/o NKK Corporation
1-2 Marunouchi 1-chome
Chiyoda-ku, Tokyo(JP)
Inventor: Kaneto, Takeshi, c/o NKK
Corporation
1-2 Marunouchi 1-chome
Chiyoda-ku, Tokyo(JP)
Inventor: Shima, Yoshinobu, c/o NKK
Corporation
1-2 Marunouchi 1-chome
Chiyoda-ku, Tokyo(JP)

(74) Representative: Marsh, Roy David et al
Urquhart-Dykes & Lord 419B Midsummer
House Midsummer Boulevard
Central Milton Keynes MK9 3BN(GB)

(54) Apparatus of manufacturing silicon single crystals.

(57) In a silicon single crystal manufacturing apparatus of the type which charges silicon material continuously, a heat radiation shield is arranged above a single crystal growing section to shield and adjust the radiation of heat from the surface of molten silicon in the single crystal growing section. In the apparatus, to reduce the concentration of oxygen in a single crystal requires that the amount of oxygen in the molten silicon is decreased and the temperature of a crucible must be decreased for this purpose. In order to decrease the temperature of the crucible, it is an important point to shield the radiation of heat from the surface of the molten silicon. In accordance with the present invention, a heat radiation shield (14) is provided as a measure for this important point. The heat radiation shield (14) is composed of a fibrous refractory, a fibrous refractory covered with a metal plate, a multilayer metal sheet assembly or an electric resistance heating element. Also, the interior of the crucible is divided by a partition member (11) and it is formed with a plurality of small holes (12) or a quartz pipe is arranged on the inner side of the partition member (11) to extend along the circumferential direction thereof, thereby causing the molten silicon (4) to smoothly move from a material melting section to the single crystal growing section and thus providing an effective measure.

FIG. 1

## APPARATUS OF MANUFACTURING SILICON SINGLE CRYSTALS

BACKGROUND OF THE INVENTION

Field of the Invention

The present invention relates to an apparatus for manufacturing silicon single crystals by the Chochralski method.

Description of the Prior Art

Methods of manufacturing silicon single crystals by the Chochralski method while continuously charging silicon material (hereinafter simply referred to as CC-CZ methods) have been known for a long time (e.g., Japanese Patent Publication No. 40-10184, P1, L20 to L35). Fig. 8 shows a schematic construction of such method.

In the Figure, numeral 1 designates a quartz crucible, 4 molten silicon, 5 a silicon single crystal, 6 a heater, 11 a partition member, 12 small holes formed through the partition member 11, and 16 granular silicon material. A is a material melting section and B is a single crystal growing section.

This CC-CZ method is advantageous in that the amount of oxygen dissolved from the quartz crucible 1 is always constant. The reason is that the same weight of the silicon granular material 16 as the increase in the weight of the silicon single crystal 5 being pulled is continuously fed into the molten silicon so that the amount of the melt in the quartz crucible 1 is always maintained constant. As a result, the concentration of oxygen along the longitudinal direction of the silicon single crystal 5 is maintained constant at any position. This is the same with the concentration of the dopant in the silicon single crystal. In other words, if the same amount of the dopant as the amount of the dopant taken into the silicon single crystal 5 being pulled is continuously added to the molten silicon, the concentration of the dopant in the single crystal can be maintained constant along its longitudinal direction. Silicon single crystals which are high in quality and yield can be manufactured as compared with the conventional Chochralski method (hereinafter simply referred to as a CZ method).

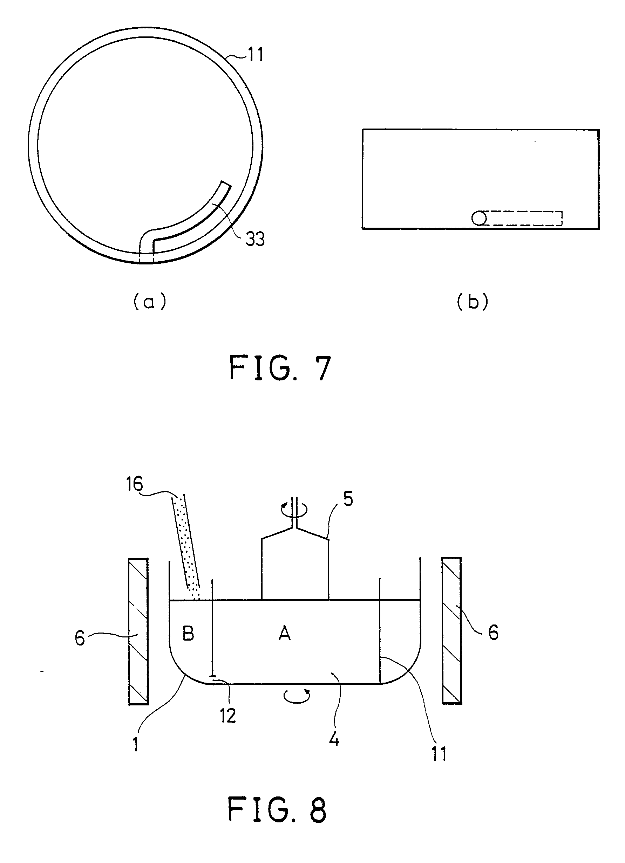

As described hereinabove, the CC-CZ method of the basic construction shown in Fig. 8 is advantageous over the conventional CZ method. Particularly, it is epoch-making that silicon single crystals of the same concentration of oxygen along the whole longitudinal direction can be manufactured.

However, the level of oxygen concentration is considerably high as compared with the level of oxygen concentration in single crystals produced by the conventional Chochralski method. The cause has not been clear and there has been problem that it is difficult to decrease the level of oxygen concentration.

The concentration of oxygen in silicon is an important factor which determines the quality of ICs. It is necessary to decrease the level of oxygen concentration at least to the level obtained by the conventional CZ method and until now no such technique as to reduce the oxygen concentration has been proposed.

The inventors have found out that the concentration of oxygen in the single crystals grown by the CC-CZ method is considerably high for the following reasons.

The oxygen in the molten silicon is supplied by the dissolution of the quartz crucible. The oxygen concentration is determined by the amount of dissolution of the quartz crucible. The amount of dissolution of the crucible is determined by the contact area between the melt and the crucible and the temperature on the crucible surface. The following differences are presumed to exist between the ordinary CZ method and CC-CZ method employing a double structure crucible of the type having a quartz partition member in the quartz crucible.

First, the use of the double structure crucible increases considerably the contact area between the molten silicon and the quartz. As a result, the amount of dissolved oxygen is also increased in accordance with the increase in the contact area. In addition, dissolution of the quartz crucible is greatly enhanced by the increase in the temperature. For instance, if the temperature of the quartz crucible is increased by $10°C$ from about $1460°C$, the dissolution rate of the quartz crucible per unit area is increased by about 20%. Furthermore, the use of the double structure crucible needs a considerably larger crucible than ordinary single-structure ones in order to provide an additional material melting section for heating and melting the silicon material charged continuously.

Thus, the furnace body is increased in size and the opening above the crucible is widened. Therefore, the amount of heat dissipated from the melt surface in the single crystal growing region, which is directly related to the concentration of oxygen in the single crystal, is increased as compared with the conventional CZ method. Even if the temperature of the molten silicon is the same with that of the ordinary CZ method, the amount of heat input to the molten silicon must be increased as compared with the ordinary CZ method. The temperature of the quartz crucible, which is the principal source of heat. must inevitably be increased. Then, in the case of the CC-CZ method employing the double structure crucible, the surface temperature of the quartz crucible is increased and the dissolution of the quartz crucible forming the source of oxygen is estimated to be more intense than the ordinary CZ method.

Also, a method is known in which a torus cover member and a heating member are arranged above the material melting section so as to melt rapidly the silicon material fed continuously (Laid-Open Patent No. 1-96087). However, if such method is used, the temperature of the molten silicon in the material melting section is increased considerably as compared with the single crystal growing section. This means that the dissolution rate per unit area of the quartz crucible in the material melting section is extremely increased as compared with the single crystal growing section. Thus, if the molten silicon in the material melting section is allowed to flow in a large amount into the single crystal growing section, the oxygen concentration in the single crystal growing section is increased greatly. Also, this method is intended for the heat insulation and the heating of the material melting section and therefore it does not have the effect of preventing the radiation of the heat from the molten silicon surface in the single crystal growing section. It is also presumed that the temperature of the quartz crucible enclosing the single crystal growing section is also increased as compared with the ordinary CZ method.

For the reasons described above, the silicon single crystal produced by the continuous-feed CZ method employing the existing double structure crucible is such that the oxygen concentration along the longitudinal direction is constant but the oxygen concentration level is high.

SUMMARY OF THE INVENTION

The present invention has been made with a view to solving the problems due to the above-mentioned presumed causes and it is an object of the present invention to provide a silicon single crystal manufacturing apparatus so designed that the features of CC-CZ method are utilized and also the amount of the oxygen in molten silicon is reduced to lower the oxygen concentration level along the longitudinal direction of a silicon single crystal.

To accomplish the above object, in accordance with the present invention there is thus provided a silicon single crystal manufacturing apparatus which is provided with a heat radiation shield arranged above the molten silicon to adjust the amount of heat radiation from the surface of the molten silicon, thereby controlling the concentration of oxygen in the molten silicon within a single crystal growing section. The heat radiation shield may have any one of the following structures.

(a) The heat radiation shield is made from a fibrous refractory and the amount of the refractory is adjusted to control the degree of shielding the heat radiation Also, the fibrous refractory is covered with a metal plate.

(b) The heat radiation shield is composed of a multi-layer metal sheet assembly with a gap between the individual metal sheets and the number of metal sheets is adjusted to control the degree of shielding the heat radiation.

(c) The heat radiation shield is composed of an electric resistance heating element and the amount of current flow is adjusted to control the degree of shielding the heat radiation.

In addition, the apparatus includes a mechanism whereby the molten silicon is moved from a material melting section to the single crystal growing section in an amount required to maintain the molten silicon levels of the material melting section and the single crystal growing section equal to each other.

By employing the above-mentioned means of the present invention in the apparatus which uses the double structure crucible to pull a silicon single crystal from the single crystal growing section, the following effects can be produced.

First, by arranging the heat radiation shield above the crucible, the radiation of heat from the molten silicon surface in the single crystal growing section and the upper part of the partition member can be reduced. Then, the temperature of the quartz crucible wall enclosing the single crystal growing section is made uniform and also its average temperature is decreased. As a result, the amount of dissolution of the quartz crucible enclosing the single crystal growing section is decreased.

In addition, the molten silicon being moved from the material melting section to the silicon single crystal growing section is allowed to move smoothly in one direction in an amount only required for maintaining the molten silicon surfaces in the material melting section and the single crystal growing section at a constant level. When this occurs, the amount of oxygen supplied from the material melting section to the single crystal growing section amounts to several of the oxygen quantity supplied by the dissolution of the quartz crucible enclosing the single crystal growing section and thus it can be ignored. In other words, the amount of dissolution of the quartz crucible in the material melting section has practically no effect on the concentration of oxygen in the molten silicon in the single crystal growing section. As a result, it is only necessary to consider only the amount of oxygen supplied from the quartz crucible surface enclosing the single crystal growing section. In this case, the surface area of the quartz crucible as a source of oxygen becomes substantially equal to the surface area of the quartz crucible used by the ordinary CZ method for the same amount of molten silicon.

BRIEF DESCRIPTION OF THE DRAWINGS

Figs. 1, 2 and 3 are sectional views showing schematically an embodiment of the present invention.

Fig. 4 is a graph useful for explaining the effect of the present invention.

Figs. 5 , 6 and 7 are partial sectional views showing other embodiments of the present invention.

Fig. 8 is a schematic diagram for explaining a silicon single crystal manufacturing apparatus by the CC-CZ method employing a double structure crucible.

DESCRIPTION OF THE PREFERRED EMBODIMENTS

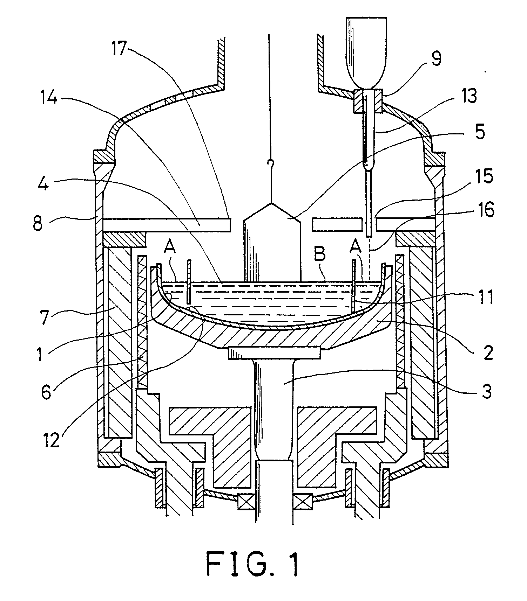

Fig. 1 is a sectional view showing schematically a silicon single crystal manufacturing apparatus according to an embodiment of the present invention. In the Figure, numeral 1 designates a quartz crucible set inside a graphite crucible 2. The graphite crucible 2 is supported on a pedestal 3 so as to be vertically movable and rotatable. Numeral 4 designates molten silicon material contained inside the crucible 1. A silicon single crystal 5 grown into a cylindrical shape from the molten silicon is rotated and pulled. Numeral 6 designates a heater surrounding the graphite crucible 2, and 7 a hot-zone heat insulator enclosing the heater 6. These component parts are basically the same with the counterparts of the single crystal manufacturing apparatus by the ordinary CZ method.

Numeral 11 designates a cylindrical partition member (an inner crucible) made from a high-purity quartz. Numeral 14 designates a heat radiation shield. The outer peripheral part of the heat radiation shield 14 is supported on the hot-zone heat insulator 7 and it is set to cover the molten material 4.

Numeral 13 designates a granular starting material feeder, 15 a hole formed for the feed path of granular silicong material 16, and 17 a circular opening formed so as not to impede the pulling of a single crystal but adjust the amount of heat radiation.

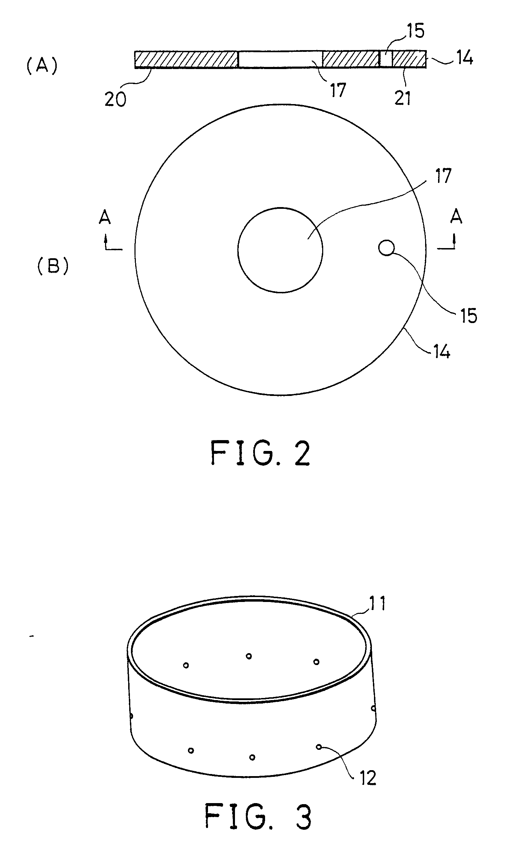

Fig. 2 shows the heat radiation shield. Fig. 2(a) is a sectional view and Fig. 2(b) is a plan view. The shield is composed of a fibrous refractory enclosed with a metal plate. The heat radiation shield 14 is arranged above the molten silicon and therefore it must not become a source of contamination. It is conceivable that during its use over a long period of time the fibrous refractory peels off and becomes a source of contamination to the molten siliooon. Therefore, the heat radiation shield is covered with the metal plate as in the present embodiment.

Fig. 3 shows the partition member 11. The partition member 11 is formed with 8 small holes 12 of 3 to 2mm in diameter and they are arranged symmetrically with the center of the crucible. The high-temperature molten starting material in a material melting section A flows smoothly toward a single crystal growing section B through the small holes 12.

In the present invention constructed as described above, the heat radiation shield 14 functions in a heat insulating manner. By adjusting the thickness of the heat radiation shield 14 or the area of the opening 17, it is possible to arbitrarily reduce and control the amount of heat radiation from the molten silicon 4.

If the amount of heat radiation from the molten silicon is suppressed by the heat radiation shield member 14, the temperature of the heater 6 can be decreased. As a result, the temperature of the quartz crucible 1 surrounded by the heater 6 is decreased and the amount of dissolution of the quartz crucible into the molten silicon is decreased. Thus, the concentration of oxygen in the molten silicon can be decreased.

Moreover, the communication between the material melting section and the single crystal growing section through the small holes has the effect of limiting the amount of molten silicon flowing into the single crystal growing section from the material melting section to the minimum required amount. As a result, the amount of oxygen supplied to the single crystal growing section from the material melting section is reduced to a negligible level. In other words, the amount of the oxygen in the single crystal growing section is determined only by the amount of dissolution of the quartz crucible enclosing the molten silicon in the single crystal growing section.

As described hereinabove, the amount of dissolution of the quartz crucible can be controlled by the heat radiation shield. Therefore, it is possible to produce silicon single crystals which are lower in oxygen concentration by 3 to 6 p.p.ma than those obtained in the cases where the measure of the present invention is not employed. Such low oxygen concentration silicon single crystals have never been manufactured by the conventional CC-CZ method.

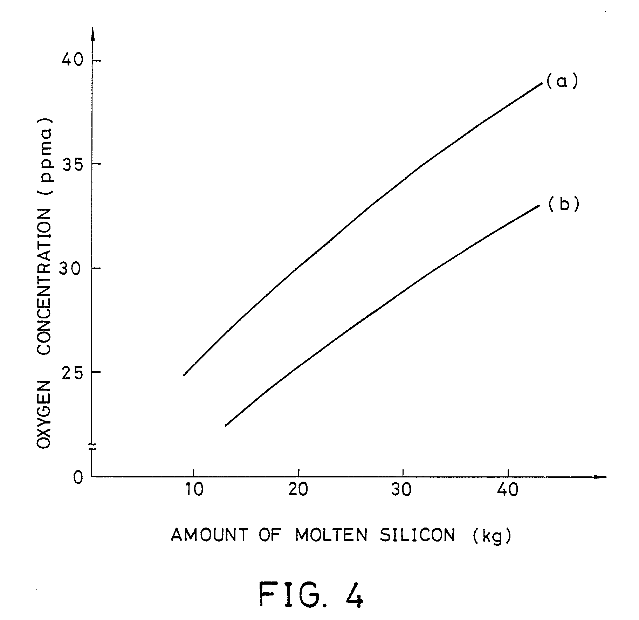

Fig. 4 is a graph showing the relation between the amount of molten silicon and the concentration of oxygen in cases where the present invention is effected. In the Figure, the curve (a) shows the case of the conventional method and the curve (b) shows the case of the present invention. When the method is performed by the apparatus disclosed in Japanese Laid-Open Patent No. 1-96087, the results are substantially the same with the curve (a) and it is seen that the conventional method does not produce much effect with respect to the reduction of the oxygen concentration.

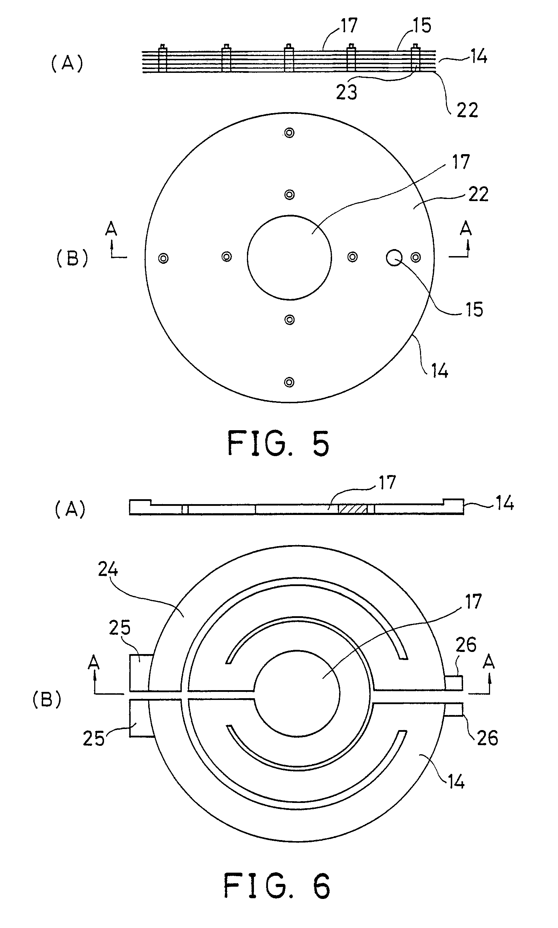

Fig. 5 shows another embodiment of the heat radiation supressing member 14. Metal sheets (22) are formed into a multi-layer structure using spacers (23). In order to enhance the heat insulating effect, consideration is given so that the individual metal sheets are prevented from contacting with one another. The metal sheets must be such that they suit their use environment. More specifically, the metal sheets must possess such properties as resistance to heat, resistance to chemical reactions and high temperature strength. In the present embodiment, molybdenum sheets of 0.5mm thick are used. However, molybdenum tends to form an oxide when it contacts with carbon at elevated temperatures and therefore silica glass is interposed between the heat radiation shield 14 and the hotzone heat insulator 7.

Fig. 6 shows another embodiment of the heat radiation shield. Fig. 6B is a plan view. Fig. 6A is a sectional view taken along the line A-A of the heat radiation shield (B). According to this embodiment, the heat radiation shield 14 is composed of an electric resistance heating element 24. In this embodiment, the temperature of the heating element 24 is adjusted to control the amount of heat radiation from the molten silicon 4. This temperature control is effected by controlling the current supply through terminals 25. As compared with the case employing the previously mentioned fibrous refractory 20 as the heat radiation shield, it is possible to perform more sophisticated heat radiation suppression control.

It is to be noted that the heat radiation shield 14 is fixed from above by means of the terminals 25 and supporting portions 26 and arranged in place so as not to contact with the hot-zone heat insulator 7.

Fig. 7 shows another embodiment of the invention in which the partition member is provided with a quartz pipe 33. The quartz pipe is arranged to extend along the circumferential direction of the partition member. According to this embodiment, a pipe of 10mm in inner diameter and 10cm in length is arranged on the inner side of the partition member. Even with this quartz pipe, it is possible to attain a unidirectional flow of the molten silicon from the material melting section to the single crystal growing section.

From the foregoing description it will be seen that in accordance with a silicon single crystal manufacturing apparatus of this invention including a rotatable quartz crucible containing molten silicon, a quartz partition member for dividing the interior of the quartz crucible into an inner single crystal growing section and an outer material melting section, a plurality of small holes formed through the partition member, a heater constructed so as to enclose the side of the quartz crucible, and means for continuously feeding silicon starting material into the material melting section, the following effects can be obtained.

The amount of dissolution of the quartz crucible within the single crystal growing section can be controlled in accordance with the material and shape of the heat radiation suppressing member arranged above the molten silicon.

Also, the molten silicon is allowed to flow in one direction from the material melting section to the single crystal growing section and thus the amount of oxygen supplied from the material melting section to the single crystal growing section can be reduced to a level that can be ignored. In other words, the concentration of oxygen within the single crystal growing section is dependent only on the amount of dissolution of the quartz crucible surrounding the single crystal growing section.

As a result, it is possible to grow a silicon single crystal of a low oxygen concentration level even by the CC-CZ. The working of the present invention has a great effect.

## Claims

1. A silicon single crystal manufacturing apparatus comprising:
a rotating quartz crucible containing molten silicon;
a quartz partition member for dividing an interior of said quartz crucible into an inner single crystal growing seotion and an outer material melting section;
at least one small hole formed through said quartz partition member;
a heater of a construction surrounding the side of said quartz crucible;
means for continuously charging silicon material into said material melting section; and
a heat radiation shield including a portion for shielding heat radiation from a surface of the molten silicon in said single crystal growing section, and an opening formed near to a center of said shielding portion to adjust an amount of heat radiation, said heat radiation shield being arranged above said single crystal growing section to reduce and adjust the amount of oxygen in said molten silicon.

2. A silicon single crystal manufacturing apparatus according to claim 1, wherein said heat radiation shield is made from a fibrous refractory whereby an amount of said refractory is adjusted to provide a proper amount of heat radiation.

3. A silicon single crystal manufacturing apparatus according to claim 2, wherein said fibrous refractory is covered with a metal plate.

4. A silicon single crystal manufacturing apparatus according to claim 1, wherein said heat radiation shield comprises a multilayer metal sheet assembly having a gap between metal sheets thereof whereby an amount of heat radiation is made proper by adjusting the number of said metal sheets.

5. A silicon single crystal manufacturing apparatus according to claim 1, wherein said heat radiation shield comprises an electric resistance heating element whereby an amount of current flow is controlled to adjust an amount of heat radiation.

6. A silicon single crystal manufacturing apparatus according to claim 1, wherein a plurality of said small holes are formed through said quartz partition member such that said molten silicon is smoothly moved from said material melting section to said single crystal growing section in an amount required to maintain the surface levels of the molten silicon in said material melting section, and said single crystal growing section at the same level.

7. A silicon single crystal manufacturing apparatus according to claim 1, wherein a quartz pipe is arranged on an inner side of said quartz partition member to extend along a circumferential direction thereof such that said molten silicon is smoothly moved from said material melting section to said single crystal growing section in an amount required for maintaining the surface levels of said molten silicon in said material melting section and said single crystal growing section at the same level.

FIG. 1

(A)

20  17  21  15  14

(B)

A    A

17

15

14

FIG. 2

11

12

FIG. 3

EP 0 390 503 A1

FIG. 4

FIG. 5

FIG. 6

(a)

11

33

(b)

# FIG. 7

16

5

6

B

A

6

1

12

4

11

# FIG. 8

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 8, no. 156 (C-234)[1593], 19th July 1984; & JP-A-59 57 992 (KOGYO GIJUTSUIN (JAPAN)) 03-04-1984 | 1 | C 30 B 15/12<br>C 30 B 15/14 |
| A | IBM TECHNICAL DISCLOSURE BULLETIN, vol. 28, no. 1, June 1985, pages 211-212, New York, US; "Apparatus for low to medium level oxygen czochralski silicon crystal growth"<br>* Page 211, paragraph 1; figure * | 1 | |
| A | DE-A-2 821 481 (WACKER-CHEMITRONIC GESELLSCHAFT FÜR ELEKTRONIK-GRUNDSTOFFE mbH)<br>* Claim 1; page 5, paragraph 4; figure * | 1,3,4 | |
| A | EP-A-0 229 322 (SHIN-ETSU HANDOTAI CO., LTD)<br>* Claims 1,3-5 * | 1-3 | TECHNICAL FIELDS SEARCHED (Int. Cl.5) |
| A | EP-A-0 303 409 (UNITED KINGDOM ATOMIC ENERGY AUTHORITY)<br>* Abstract * | 1,5 | C 30 B |
| A | EP-A-0 293 865 (MITSUBISHI KINZOKU K.K.)<br>* Abstract * | 1,6 | |

The present search report has been drawn up for all claims

| Place of search | Date of completion of the search | Examiner |
|---|---|---|
| THE HAGUE | 04-07-1990 | GREGG N.R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)